# EUROPÄISCHE PATENTSCHRIFT

(11) **EP 3 251 474 B1**
(45) Veröffentlichungstag und Bekanntmachung des Hinweises auf die Patenterteilung: **17.02.2021**
(21) Anmeldenummer: 15822914.6
(22) Anmeldetag: 18.12.2015
(51) Int. Cl.: H05K 7/14, H05K 1/02

(54) **ELEKTROGERÄT**
ELECTRICAL DEVICE
APPAREIL ELECTRIQUE

(30) Priorität: 28.01.2015 DE 102015000938
(43) Veröffentlichungstag der Anmeldung: 06.12.2017
(73) Patentinhaber: SEW-EURODRIVE GmbH & Co. KG, 76646 Bruchsal (DE)
(72) Erfinder: MOMANN , Dirk, 76646 Bruchsal (DE); KOLBERT, Alexander, 76356 Weingarten (DE)
(86) Internationale Anmeldenummer: PCT/EP2015/002559
(87) Internationale Veröffentlichungsnummer: WO 2016/119807

(56) Entgegenhaltungen:
- DE-A1- 10 108 767
- DE-A1-102005 062 770

## Beschreibung

Die Erfindung betrifft ein Elektrogerät, insbesondere Umrichter.

Aus der DE 10 2005 054 601 A1 ist ein Elektrogerät mit Steckverbindern bekannt.

Die DE 10 2005 062 770 A1 zeigt ein System und Verfahren zum Schutz eines elektrischen Bauteils gegen einen Stoß oder wiederholte mechanische Beanspruchung.

In der DE 101 08 767 A1 ist eine elektronische Steuereinheit mit flexiblen Drähten, welche ein Verbindungsglied mit einer Leiterplatte verbinden, gezeigt.

Der Erfindung liegt daher die Aufgabe zugrunde, ein Elektrogerät weiterzubilden, wobei der Umweltschutz verbessert werden soll.

Erfindungsgemäß wird die Aufgabe bei dem Elektrogerät nach den in Anspruch 1 angegebenen Merkmalen gelöst.

Wichtige Merkmale der Erfindung bei dem Elektrogerät, insbesondere Umrichter, aufweisend
- eine erste Leiterplatte, aufweisend erste Leiterbahnen und zumindest eine Durchkontaktierung,
- eine zweite Leiterplatte, aufweisend zweite Leiterbahnen und zumindest ein Verbindungsmittel,
- ein Leistungsmodul,
- und ein Steckverbinderteil,
sind, dass
das Leistungsmodul auf der ersten Leiterplatte bestückt ist und mittels der ersten Leiterbahnen mit der Durchkontaktierung elektrisch leitend verbunden ist,
wobei das Steckverbinderteil auf der zweiten Leiterplatte bestückt ist und mittels der zweiten Leiterbahnen mit dem Verbindungsmittel elektrisch leitend verbunden ist,
wobei die Durchkontaktierung mittels eines Kabels elektrisch leitend mit dem Verbindungsmittel verbunden ist.

Von Vorteil ist dabei, dass das Elektrogerät kompakt ausführbar ist, da die Leiterplatten beabstandet voneinander anordenbar sind. Dabei sind die Leiterplatten in Normalenrichtung zu einer Leiterplattenebene beabstandbar, beispielsweise parallel anordenbar.

Die Position des Steckverbinders am Elektrogerät ist unabhängig von der Lage der ersten Leiterplatte im Elektrogerät wählbar.

Vorteilhafterweise ist die zweite Leiterplatte kleiner als die erste Leiterplatte ausführbar.

Vorteilhafterweise ist Leiterplattenmaterial einsparbar. Somit ist der Umweltschutz verbessert.

Bei einer vorteilhaften Ausgestaltung ist ein Endbereich des Kabels in die Durchkontaktierung eingeführt und mit der Durchkontaktierung Iötverbunden. Von Vorteil ist dabei, dass das Kabel in einfacher Art und Weise mit der Durchkontaktierung sicher verbindbar ist.

Bei einer vorteilhaften Ausgestaltung ist das Verbindungsmittel auf der zweiten Leiterplatte bestückt. Von Vorteil ist dabei, dass das Verbindungsmittel aus der Leiterplattenebene der zweiten Leiterplatte hervorsteht. Somit ist das Kabel auf das Verbindungsmittel aufsteckbar. Vorteilhafterweise erstreckt sich das Kabel in Querrichtung zur Normalenrichtung der Leiterplattenebene der zweiten Leiterplatte. Somit ist ein Kabelbruch des Kabels bei kompakter Ausführung des Elektrogeräts verhinderbar und die Sicherheit des Elektrogeräts ist verbessert.

Bei einer vorteilhaften Ausgestaltung weist die zweite Leiterplatte eine Leiterplattenebene auf und das Verbindungsmittel kragt von der zweiten Leiterplatte senkrecht zur Normalenrichtung der Leiterplattenebene aus. Von Vorteil ist dabei, dass das Verbindungsmittel sich weiter in einen Innenraum des Elektrogerätes hinein erstreckt als die zweite Leiterplatte. Somit ist das Kabel beabstandet von der zweiten Leiterplatte anordenbar. Vorteilhafterweise erstreckt sich das Kabel im Wesentlichen parallel zur Normalenrichtung der Leiterplattenebene.

Bei einer vorteilhaften Ausgestaltung ist ein weiterer Endbereich des Kabels auf das Verbindungsmittel gesteckt. Von Vorteil ist dabei, dass das Kabel in einfacher Art und Weise mit dem Verbindungsmittel sicher verbindbar ist. Vorteilhafterweise ist das Kabel mit dem Verbindungsmittel quetschverbindbar, insbesondere mittels eines Crimpverbinders.

Bei einer vorteilhaften Ausgestaltung ist das Verbindungsmittel als Durchkontaktierung in der zweiten Leiterplatte ausgeführt. Von Vorteil ist dabei, dass die Durchkontaktierung in einem Arbeitsgang mit den zweiten Leiterbahnen auf der zweiten Leiterplatte fertigbar ist. Somit ist der Arbeitsaufwand reduzierbar und der Umweltschutz ist verbessert.

Bei einer vorteilhaften Ausgestaltung ist ein weiterer Endbereich des Kabels in das Verbindungsmittel eingeführt und mit dem Verbindungsmittel Iötverbunden. Von Vorteil ist dabei, dass das Kabel in einfacher Art und Weise mit dem Verbindungsmittel sicher verbindbar ist.

Erfindungsgemäß sind auf der ersten Leiterplatte ein weiteres Leistungsmodul und ein weiteres Steckverbinderteil bestückt, wobei die erste Leiterplatte weitere Leiterbahnen aufweist, wobei das weitere Leistungsmodul mittels der weiteren Leiterbahnen mit dem weiteren Steckverbinderteil verbunden ist. Von Vorteil ist dabei, dass zwei Elektromotoren unabhängig voneinander mittels des Elektrogerätes speisbar sind. Vorteilhafterweise ist ein identisches Leiterplattenlayout verwendbar für ein Elektrogerät zur Speisung von einem Elektromotor und für ein Elektrogerät zur Speisung von zwei Elektromotoren. Somit ist ein Baukasten für Umrichter mit einer reduzierten Teilezahl ausführbar und der Umweltschutz ist verbessert.

Bei einer vorteilhaften Ausgestaltung weist das Elektrogerät einen einzigen Gleichspannungszwischenkreis auf, mit dem das Leistungsmodul und das weitere Leistungsmodul elektrisch leitend verbunden sind, insbesondere aus dem die Leistungsmodule gespeist sind. Von Vorteil ist dabei, dass aus jedem Leistungsmodul jeweils ein Elektromotor speisbar ist. Vorteilhafterweise ist elektrische Energie, die mit einem Elektromotor generatorisch erzeugt wird, in den anderen Elektromotor einspeisbar. Somit ist ein Energiekreislauf eingerichtet und der Umweltschutz ist verbessert.

Bei einer vorteilhaften Ausgestaltung weist der Gleichspannungszwischenkreis einen einzigen Kondensator auf. Von Vorteil ist dabei, dass elektrische Bauteile einsparbar sind. Also ist der Umweltschutz verbessert.

Bei einer vorteilhaften Ausgestaltung weist das Elektrogerät zumindest ein Gehäuseteil auf, wobei das Gehäuseteil zumindest eine Ausnehmung aufweist, wobei das Steckverbinderteil durch die Ausnehmung zumindest teilweise hindurchgeführt ist. Von Vorteil ist dabei, dass das Steckverbinderteil in einfacher Art und Weise mit dem Gehäuseteil verbindbar ist, insbesondere klipsverbindbar.

Bei einer vorteilhaften Ausgestaltung ist das weitere Steckverbinderteil durch die Ausnehmung oder eine weitere Ausnehmung zumindest teilweise hindurchgeführt. Von Vorteil ist dabei, dass das weitere Steckverbinderteil in einfacher Art und Weise mit dem Gehäuseteil verbindbar ist, insbesondere klipsverbindbar.

Bei einer weiteren vorteilhaften Ausgestaltung ist die zweite Leiterplatte lösbar mit dem Gehäuseteil verbunden. Von Vorteil ist dabei, dass die zweite Leiterplatte in einfacher Art und Weise austauschbar ist.

Bei einer vorteilhaften Ausgestaltung ist ein Halteteil an dem Gehäuseteil angeordnet, insbesondere formschlüssig mit dem Gehäuseteil verbunden, insbesondere vernietet, wobei die zweite Leiterplatte lösbar mit dem Halteteil verbunden ist, insbesondere mittels eines Schraubteils verbunden ist. Von Vorteil ist dabei, dass die zweite Leiterplatte in einfacher Art und Weise mit dem Gehäuseteil verbindbar ist mittels des Halteteils.

Vorteilhafterweise spannt das Gehäuseteil eine Ebene auf, wobei diese Ebene in einem nichtverschwindenden Winkel zur Leiterplattenebene der zweiten Leiterplatte anordenbar ist.

Vorteilhafterweise ist das Verbindungsmittel und/oder das Kabel beabstandbar von dem Gehäuseteil mittels des Halteteils.

Vorteilhafterweise ist das Halteteil als Stanzbiegeteil, insbesondere Stanzbiegeblechteil, ausführbar.

Bei einer vorteilhaften Ausgestaltung ist die zweite Leiterplatte elektrisch leitend verbunden mit dem Gehäuseteil mittels des Halteteils und des Schraubteils. Von Vorteil ist dabei, dass die zweite Leiterplatte erdbar ist mittels des geerdeten Gehäuseteils.

Bei einer vorteilhaften Ausgestaltung weist das Gehäuseteil Ausnehmungen zur Belüftung auf, insbesondere zur Belüftung des Elektrogerätes. Von Vorteil ist dabei, dass auf der ersten Leiterplatte bestückte elektrische Bauteile konvektiv oder mittels eines Lüfters kühlbar sind. Somit ist die Sicherheit verbessert.

Bei einer vorteilhaften Ausgestaltung ist das Gehäuseteil als Metallblechteil, insbesondere Stanzbiegeblechteil, ausgeführt, wobei die Ausnehmungen zur Belüftung und die Ausnehmung und/oder die weitere Ausnehmung als Ausstanzungen in dem Metallblechteil ausgeführt sind. Von Vorteil ist dabei, dass das Gehäuseteil in einfacher Art und Weise fertigbar ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:

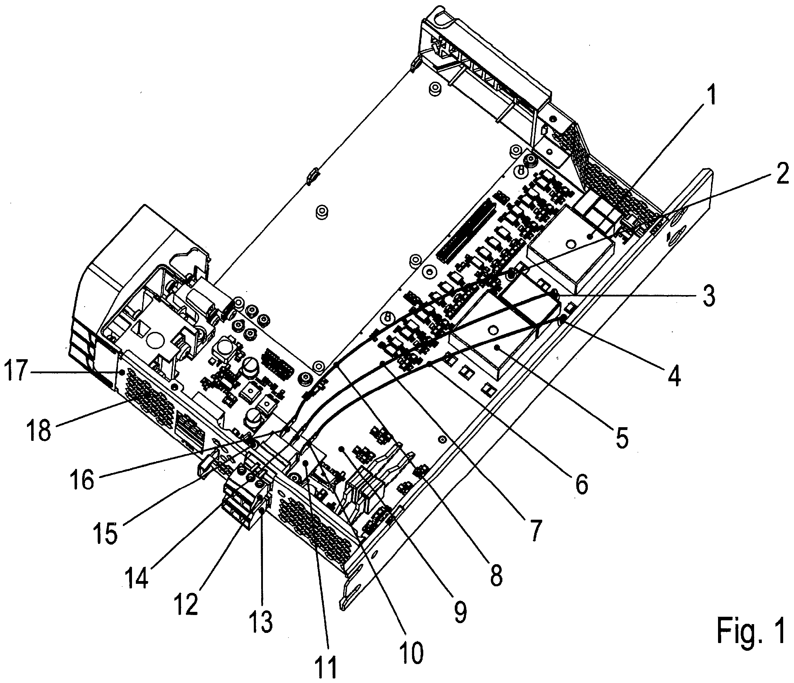

In der Figur 1 ist ein erfindungsgemäßes Elektrogerät in Schrägansicht gezeichnet.

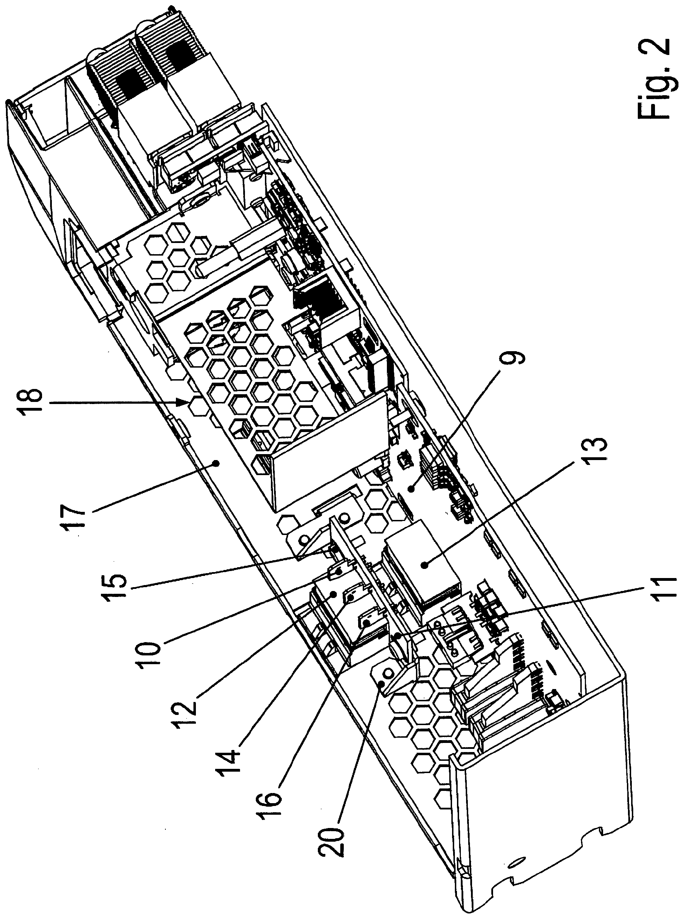

Figur 2 zeigt eine Schnittansicht des erfindungsgemäßen Elektrogeräts.

Das erfindungsgemäße Elektrogerät, vorzugsweise ein Umrichter, weist eine erste Leiterplatte 9 auf, auf der ein Leistungsmodul 5 und ein weiteres Leistungsmodul 1 bestückt sind.

Jedes Leistungsmodul (1, 5) weist einen Wechselrichter, umfassend steuerbare Halbleiterleistungsschalter, insbesondere IGBTs, auf.

Das Elektrogerät weist einen Gleichrichter und einen aus diesem gespeisten Gleichspannungszwischenkreis auf. Vorzugsweise sind beide Leistungsmodule (1, 5) aus einem einzigen gemeinsamen Gleichspannungszwischenkreis gespeist.

Das Leistungsmodul 5 ist mittels erster Leiterbahnen auf der ersten Leiterplatte 9 mit drei Durchkontaktierungen (2, 3, 4) in der ersten Leiterplatte 9 verbunden. Dazu weist das Leistungsmodul 5 elektrische Kontaktmittel auf, die mit den ersten Leiterbahnen lötverbunden sind.

Die Durchkontaktierungen (2, 3, 4) sind elektrisch leitend mit jeweils einem Kabel (6, 7, 8) verbunden. Dazu ist jeweils ein erster Endbereich jedes Kabels (6, 7, 8) in die jeweilige Durchkontaktierung (2, 3, 4) eingeführt und mit der jeweiligen Durchkontaktierung (2, 3, 4) Iötverbunden.

Ein jeweiliger zweiter Endbereich jedes Kabels (6, 7, 8) ist elektrisch leitend mit einem jeweiligen Verbindungsmittel (10, 14, 16) verbunden. Die Verbindungsmittel (10, 14, 16) sind auf einer zweiten Leiterplatte 11 angeordnet, insbesondere bestückt. Auf der zweiten Leiterplatte 11 ist ein Steckverbinderteil 12 bestückt. Die Verbindungsmittel (10, 14, 16) sind mittels zweiter Leiterbahnen auf der zweiten Leiterplatte 11 elektrisch leitend mit dem Steckverbinderteil 12 verbunden. Dazu weisen die Verbindungsmittel (10, 14, 16) und das Steckverbinderteil 12 elektrische Kontaktmittel auf, die mit den zweiten Leiterbahnen lötverbunden sind.

Das Steckverbinderteil 12 ist zum Verbinden mit einem Gegensteckverbinderteil eingerichtet. Das Gegensteckverbinderteil ist beispielsweise mit einem Elektromotor elektrisch leitend verbunden, so dass der Elektromotor speisbar ist mittels des Elektrogerätes, insbesondere speisbar aus dem Leistungsmodul 5.

Das Elektrogerät weist zumindest ein Gehäuseteil 17 auf. Das Steckverbinderteil 12 ist durch eine Ausnehmung in dem Gehäuseteil 17 teilweise hindurchgeführt und mit dem Gehäuseteil 17 und/oder der zweiten Leiterplatte 11 verbunden, insbesondere kraftschlüssig verbunden, vorzugsweise klemmverbunden.

Die zweite Leiterplatte 11 ist lösbar mit dem Gehäuseteil 17 verbunden. Dazu ist zumindest ein Halteteil 20 mit dem Gehäuseteil 17 verbunden, insbesondere vernietet. Das Halteteil 20 weist zumindest eine Bohrung auf, durch die ein Schraubteil 15 hindurchführbar ist. Die zweite Leiterplatte 11 weist zumindest eine Bohrung auf, durch die das Schraubteil 15 hindurchführbar ist. Mittels des durch die Bohrungen hindurchgeführten Schraubteils 15, das mittels einer Mutter fixierbar ist, ist die zweite Leiterplatte 11 lösbar verbunden mit dem Halteteil 20.

Das Halteteil 20 ist als Stanzbiegeteil, insbesondere Stanzbiegeblechteil, ausgeführt. Das Gehäuseteil 17 spannt eine Ebene auf. Vorzugsweise ist die zweite Leiterplatte 11 derart mit dem Gehäuseteil 17 verbunden, dass diese Ebene in einem nichtverschwindenden Winkel zur Leiterplattenebene der zweiten Leiterplatte 11 angeordnet ist, vorzugsweise ist die Leiterplattenebene der zweite Leiterplatte 11 im rechten Winkel zur Ebene des Gehäuseteils 17 angeordnet. Dabei sind die auf der zweiten Leiterplatte 11 angeordneten Halteteile 20 beabstandet von dem Gehäuseteil 17 angeordnet.

Das weitere Leistungsmodul 1 ist mittels Leiterbahnen auf der ersten Leiterplatte 9 mit einem weiteren Steckverbinderteil 13 elektrisch leitend verbunden. Das weitere Steckverbinderteil 13 ist zum Verbinden mit einem weiteren Gegensteckverbinderteil eingerichtet. Beispielsweise ist das Gegensteckverbinderteil mit einem weiteren Elektromotor elektrisch leitend verbunden, so dass der weitere Elektromotor speisbar ist mittels des Elektrogerätes, insbesondere speisbar aus dem weiteren Leistungsmodul 1.

Durch eine weitere Ausnehmung in dem Gehäuseteil 17 ist das weitere Steckverbinderteil 13 teilweise hindurchgeführt und mit dem Gehäuseteil 17 und/oder der ersten Leiterplatte 9 verbunden, insbesondere kraftschlüssig verbunden, vorzugsweise klemmverbunden.

Das Gehäuseteil 17 weist Ausnehmungen zur Belüftung 18 auf. Die Ausnehmungen zur Belüftung 18 sind zur Belüftung, insbesondere zur konvektiven Kühlung, des Elektrogerätes eingerichtet.

Das Gehäuseteil 17 ist als Stanzbiegeteil ausgeführt, insbesondere als Stanzbiegeblechteil.

Die Ausnehmung, die weitere Ausnehmung und die Ausnehmungen zur Belüftung 18 sind als durchgehende Ausnehmungen ausgeführt.

### Bezugszeichenliste

- 1: Leistungsmodul
- 2: Durchkontaktierung
- 3: Durchkontaktierung
- 4: Durchkontaktierung
- 5: Leistungsmodul
- 6: Kabel
- 7: Kabel
- 8: Kabel
- 9: Leiterplatte
- 10: Verbindungsmittel
- 11: Leiterplatte
- 12: Steckverbinderteil
- 13: Steckverbinderteil
- 14: Verbindungsmittel
- 15: Schraubteil
- 16: Verbindungsmittel
- 17: Gehäuseteil
- 18: Ausnehmung zur Belüftung
- 20: Halteteil

## Patentansprüche

1. Elektrogerät, insbesondere Umrichter, aufweisend
- eine erste Leiterplatte (9), aufweisend erste Leiterbahnen und zumindest eine Durchkontaktierung (2, 3, 4),
- eine zweite Leiterplatte (11), aufweisend zweite Leiterbahnen und zumindest ein Verbindungsmittel (10, 14, 16),
- ein Leistungsmodul (5),
- und ein Steckverbinderteil (12),
wobei das Leistungsmodul (5) auf der ersten Leiterplatte (9) bestückt ist und mittels der ersten Leiterbahnen mit der Durchkontaktierung (2, 3, 4) elektrisch leitend verbunden ist,
wobei das Steckverbinderteil (12) auf der zweiten Leiterplatte (11) bestückt ist und mittels der zweiten Leiterbahnen mit dem Verbindungsmittel (10, 14, 16) elektrisch leitend verbunden ist,
wobei die Durchkontaktierung (2, 3, 4) mittels eines Kabels (6, 7, 8) elektrisch leitend mit dem Verbindungsmittel (10, 14, 16) verbunden ist,
wobei auf der ersten Leiterplatte (9) ein weiteres Leistungsmodul (1) und ein weiteres Steckverbinderteil (13) bestückt sind,
wobei die erste Leiterplatte (9) weitere Leiterbahnen aufweist,
wobei das weitere Leistungsmodul (1) mittels der weiteren Leiterbahnen mit dem weiteren Steckverbinderteil (13) verbunden ist,
wobei aus jedem Leistungsmodul (1, 5) jeweils ein Elektromotor speisbar ist,
wobei die Steckverbinderteile (12, 13) zum Verbinden mit einem mit einem Elektromotor leitend verbundenen Gegensteckverbinderteil geeignet sind.

2. Elektrogerät nach Anspruch 1,
**dadurch gekennzeichnet, dass**
ein Endbereich des Kabels (6, 7, 8) in die Durchkontaktierung (2, 3, 4) eingeführt ist und mit der Durchkontaktierung (2, 3, 4) lötverbunden ist.

3. Elektrogerät nach mindestens einem der vorangegangenen Ansprüche,
**dadurch gekennzeichnet, dass**
das Verbindungsmittel (10, 14, 16) auf der zweiten Leiterplatte (11) bestückt ist,
insbesondere wobei die zweite Leiterplatte (11) eine Leiterplattenebene aufweist und das Verbindungsmittel (10, 14, 16) von der zweiten Leiterplatte (11) senkrecht zur Normalenrichtung der Leiterplattenebene auskragt.

4. Elektrogerät nach Anspruch 3,
**dadurch gekennzeichnet, dass**
ein weiterer Endbereich des Kabels (6, 7, 8) auf das Verbindungsmittel (10, 14, 16) gesteckt ist.

5. Elektrogerät nach Anspruch 1 oder 2,
**dadurch gekennzeichnet, dass**
das Verbindungsmittel (10, 14, 16) als Durchkontaktierung in der zweiten Leiterplatte (11) ausgeführt ist,
insbesondere wobei ein weiterer Endbereich des Kabels (6, 7, 8) in das Verbindungsmittel (10, 14, 16) eingeführt ist und mit dem Verbindungsmittel (10, 14, 16) lötverbunden ist.

6. Elektrogerät nach mindestens einem der vorangegangenen Ansprüche, **dadurch gekennzeichnet, dass**
das Elektrogerät einen einzigen Gleichspannungszwischenkreis aufweist, mit dem das Leistungsmodul (5) und das weitere Leistungsmodul (1) elektrisch leitend verbunden sind, insbesondere aus dem die Leistungsmodule gespeist sind,
insbesondere wobei der Gleichspannungszwischenkreis einen einzigen Kondensator aufweist.

7. Elektrogerät nach mindestens einem der vorangegangenen Ansprüche, **dadurch gekennzeichnet, dass**
das Elektrogerät zumindest ein Gehäuseteil (17) aufweist,
wobei das Gehäuseteil (17) zumindest eine Ausnehmung aufweist,
wobei das Steckverbinderteil (12) durch die Ausnehmung zumindest teilweise hindurchgeführt ist,
und/oder wobei das weitere Steckverbinderteil (13) durch die Ausnehmung oder eine weitere Ausnehmung zumindest teilweise hindurchgeführt ist.

8. Elektrogerät nach mindestens einem der vorangegangenen Ansprüche, **dadurch gekennzeichnet, dass**
die zweite Leiterplatte (11) lösbar mit dem Gehäuseteil (17) verbunden ist.

9. Elektrogerät nach mindestens einem der vorangegangenen Ansprüche, **dadurch gekennzeichnet, dass**
ein Halteteil (20) an dem Gehäuseteil (17) angeordnet ist, insbesondere formschlüssig mit dem Gehäuseteil verbunden, insbesondere vernietet, ist,
wobei die zweite Leiterplatte (11) lösbar mit dem Halteteil (20) verbunden ist, insbesondere mittels eines Schraubteils (15) verbunden.

10. Elektrogerät nach mindestens einem der vorangegangenen Ansprüche, **dadurch gekennzeichnet, dass**
die zweite Leiterplatte (11) elektrisch leitend verbunden ist mit dem Gehäuseteil (17) mittels des Halteteils (20) und des Schraubteils (15).

11. Elektrogerät nach mindestens einem der vorangegangenen Ansprüche, **dadurch gekennzeichnet, dass**
das Gehäuseteil (17) Ausnehmungen zur Belüftung (18) aufweist, insbesondere zur Belüftung des Elektrogerätes.

12. Elektrogerät nach mindestens einem der vorangegangenen Ansprüche, **dadurch gekennzeichnet, dass**
das Gehäuseteil (17) als Metallblechteil, insbesondere Stanzbiegeblechteil, ausgeführt ist, wobei die Ausnehmungen zur Belüftung (18) und die Ausnehmung und/oder die weitere Ausnehmung als Ausstanzungen in dem Metallblechteil ausgeführt sind.

## Claims

1. An electrical device, in particular a converter, having
- a first printed circuit board (9), having first conducting tracks and at least one feedthrough (2, 3, 4),
- a second printed circuit board (11), having second conducting tracks and at least one connecting means (10, 14, 16),
- a power module (5)
- and a plug-and-socket connector part (12),
wherein the power module (5) is fitted on the first printed circuit board (9) and is connected to the feedthrough (2, 3, 4) in an electrically conductive manner by means of the first conducting tracks,
wherein the plug-and-socket connector part (12) is fitted on the second printed circuit board (11) and is connected to the connecting means (10, 14, 16) in an electrically conductive manner by means of the second conducting tracks,
wherein the feedthrough (2, 3, 4) is connected to the connecting means (10, 14, 16) in an electrically conductive manner by means of a cable (6, 7, 8),
wherein a further power module (1) and a further plug-and-socket connector part (13) are fitted on the first printed circuit board (9),
wherein the first printed circuit board (9) has further conducting tracks,
wherein the further power module (1) is connected to the further plug-and-socket connector part (13) by means of the further conducting tracks,
wherein a respective electric motor can be supplied from each power module (1, 5),
wherein the plug-and-socket connector parts (12, 13) are suitable for connection to a counter plug-and-socket connector part connected in a conductive manner to an electric motor.

2. An electrical device according to claim 1,
**characterised in that**
an end region of the cable (6, 7, 8) is inserted into the feedthrough (2, 3, 4) and is connected to the feedthrough (2, 3, 4) by soldering.

3. An electrical device according to at least one of the preceding claims,
**characterised in that**
the connecting means (10, 14, 16) is fitted on the second printed circuit board (11),
in particular wherein the second printed circuit board (11) has a printed circuit board plane and the connecting means (10, 14, 16) protrudes from the second printed circuit board (11) in a manner perpendicular to the normal direction of the printed circuit board plane.

4. An electrical device according to claim 3,
**characterised in that**
a further end region of the cable (6, 7, 8) is placed onto the connecting means (10, 14, 16).

5. An electrical device according to claim 1 or 2,
**characterised in that**
the connecting means (10, 14, 16) is in the form of a feedthrough in the second printed circuit board (11),
in particular wherein a further end region of the cable (6, 7, 8) is inserted into the connecting means (10, 14, 16) and is connected to the connecting means (10, 14, 16) by soldering.

6. An electrical device according to at least one of the preceding claims,
**characterised in that**
the electrical device has a single DC voltage intermediate circuit to which the power module (5) and the further power module (1) are connected in an electrically conductive manner, in particular from which the power modules are supplied,
in particular wherein the DC voltage intermediate circuit has a single capacitor.

7. An electrical device according to at least one of the preceding claims,
**characterised in that**
the electrical device has at least one housing part (17),
wherein the housing part (17) has at least one opening,
wherein the plug-and-socket connector part (12) is at least partially passed through the opening, and/or wherein the further plug-and-socket connector part (13) is at least partially passed through the opening or a further opening.

8. An electrical device according to at least one of the preceding claims,
**characterised in that**
the second printed circuit board (11) is detachably connected to the housing part (17).

9. An electrical device according to at least one of the preceding claims,
**characterised in that**
a holding part (20) is arranged on the housing part (17), in particular is connected to the housing part in a form-locked manner, in particular is riveted,
wherein the second printed circuit board (11) is detachably connected to the holding part (20), in particular by means of a screw part (15).

10. An electrical device according to at least one of the preceding claims,
**characterised in that**
the second printed circuit board (11) is connected to the housing part (17) in an electrically conductive manner by means of the holding part (20) and the screw part (15).

11. An electrical device according to at least one of the preceding claims,
**characterised in that**
the housing part (17) has openings for ventilation (18), in particular for ventilation of the electrical device.

12. An electrical device according to at least one of the preceding claims,
**characterised in that**
the housing part (17) is in the form of a sheet-metal part, in particular a stamped and bent sheet-metal part,
wherein the openings for ventilation (18) and the opening and/or the further opening are in the form of punched-out portions in the sheet metal part.

## Revendications

1. Appareil électrique, en particulier variateur, présentant
- une première carte de circuit imprimé (9) présentant des premières pistes conductrices et au moins un trou métallisé (2, 3, 4),
- une deuxième carte de circuit imprimé (11) présentant des deuxièmes pistes conductrices et au moins un moyen de liaison (10, 14, 16),
- un module de puissance (5),
- et une partie connecteur (12),
dans lequel le module de puissance (5) est monté sur la première carte de circuit imprimé (9) et est relié de façon électriquement conductrice au trou métallisé (2, 3, 4) au moyen des premières pistes conductrices,
dans lequel la partie connecteur (12) est montée sur la deuxième carte de circuit imprimé (11) et est reliée de façon électriquement conductrice au moyen de liaison (10, 14, 16) au moyen des deuxièmes pistes conductrices,
dans lequel le trou métallisé (2, 3, 4) est relié de façon électriquement conductrice au moyen de liaison (10, 14, 16) au moyen d'un câble (6, 7, 8),
dans lequel un autre module de puissance (1) et une autre partie connecteur (13) sont montés sur la première carte de circuit imprimé (9),
dans lequel la première carte de circuit imprimé (9) présente d'autres pistes conductrices,
dans lequel l'autre module de puissance (1) est relié à l'autre partie connecteur (13) au moyen des autres pistes conductrices,
dans lequel un moteur électrique peut être alimenté par chaque module de puissance (1, 5),
dans lequel les parties connecteur (12, 13) sont adaptées à être reliées à une partie connecteur complémentaire reliée de façon conductrice à un moteur électrique.

2. Appareil électrique selon la revendication 1,
**caractérisé en ce**
**qu'**une zone d'extrémité du câble (6, 7, 8) est introduite dans le trou métallisé (2, 3, 4) et est reliée par brasage au trou métallisé (2, 3, 4).

3. Appareil électrique selon au moins l'une des revendications précédentes,
**caractérisé en ce**
**que** le moyen de liaison (10, 14, 16) est monté sur la deuxième carte de circuit imprimé (11),
en particulier dans lequel la deuxième carte de circuit imprimé (11) présente un plan de carte de circuit imprimé et le moyen de liaison (10, 14, 16) fait saillie de la deuxième carte de circuit imprimé (11) perpendiculairement à la direction normale du plan de carte de circuit imprimé.

4. Appareil électrique selon la revendication 3,
**caractérisé en ce**
**qu'**une autre zone d'extrémité du câble (6, 7, 8) est enfichée sur le moyen de liaison (10, 14, 16).

5. Appareil électrique selon la revendication 1 ou 2,
**caractérisé en ce**
**que** le moyen de liaison (10, 14, 16) est réalisé sous la forme d'un trou métallisé dans la deuxième carte de circuit imprimé (11),
en particulier dans lequel une autre zone d'extrémité du câble (6, 7, 8) est introduite dans le moyen de liaison (10, 14, 16) et est reliée par brasage au moyen de liaison (10, 14, 16).

6. Appareil électrique selon au moins l'une des revendications précédentes,
**caractérisé en ce**
**que** l'appareil électrique présente un seul circuit intermédiaire à tension continue auquel le module de puissance (5) et l'autre module de puissance (1) sont reliés de façon électriquement conductrice, en particulier à partir duquel les modules de puissance sont alimentés,
en particulier dans lequel le circuit intermédiaire à tension continue présente un seul condensateur.

7. Appareil électrique selon au moins l'une des revendications précédentes,
**caractérisé en ce**
**que** l'appareil électrique présente au moins une partie boîtier (17),
dans lequel la partie boîtier (17) présente au moins un évidement,
dans lequel la partie connecteur (12) est au moins partiellement passée à travers l'évidement,
et/ou dans lequel l'autre partie connecteur (13) est au moins partiellement passée à travers l'évidement ou un autre évidement.

8. Appareil électrique selon au moins l'une des revendications précédentes,
**caractérisé en ce**
**que** la deuxième carte de circuit imprimé (11) est reliée de manière amovible à la partie boîtier (17).

9. Appareil électrique selon au moins l'une des revendications précédentes,
**caractérisé en ce**
**qu'**une partie de maintien (20) est disposée sur la partie boîtier (17), en particulier est reliée par complémentarité de forme, en particulier rivetée, à la partie boîtier,
dans lequel la deuxième carte de circuit imprimé (11) est reliée de manière amovible à la partie de maintien (20), en particulier reliée au moyen d'une partie filetée (15).

10. Appareil électrique selon au moins l'une des revendications précédentes,
**caractérisé en ce**
**que** la deuxième carte de circuit imprimé (11) est reliée de façon électriquement conductrice à la partie boîtier (17) au moyen de la partie de maintien (20) et de la partie filetée (15).

11. Appareil électrique selon au moins l'une des revendications précédentes,
**caractérisé en ce**
**que** la partie boîtier (17) présente des évidements pour la ventilation (18), en particulier pour la ventilation de l'appareil électrique.

12. Appareil électrique selon au moins l'une des revendications précédentes,
**caractérisé en ce**
**que** la partie boîtier (17) est réalisée sous la forme d'une pièce en tôle, en particulier d'une pièce en tôle découpée et pliée,
dans lequel les évidements pour la ventilation (18) et l'évidement et/ou l'autre évidement sont réalisés sous la forme de découpes dans la pièce en tôle.
